**Europäisches Patentamt**

**European Patent Office**

**Office européen des brevets**

(19)

(11) Veröffentlichungsnummer : **0 027 625**
**B1**

(12) # EUROPÄISCHE PATENTSCHRIFT

(45) Veröffentlichungstag der Patentschrift :
03.11.82

(51) Int. Cl.³ : **C 23 C 11/02, C 23 C 11/08, C 08 J 7/06**

(21) Anmeldenummer : **80106218.3**

(22) Anmeldetag : **13.10.80**

(54) **Verfahren zur Herstellung von haftfähigen Schichten auf Polyolefinen.**

(30) Priorität : **17.10.79 DE 2941896**

(43) Veröffentlichungstag der Anmeldung :
**29.04.81 (Patentblatt 81/17)**

(45) Bekanntmachung des Hinweises auf die Patenterteilung : **03.11.82 Patentblatt 82/44**

(84) Benannte Vertragsstaaten :
**AT BE DE FR GB IT NL**

(56) Entgegenhaltungen :
**DD A 120 473**
**GB A 1 306 784**
**US A 4 016 305**

(73) Patentinhaber : **Ruhrchemie Aktiengesellschaft**
**Bruchstrasse 219**
**D-4200 Oberhausen 13 (DE)**

(72) Erfinder : **Cornils, Boy, Dr., Dipl.-Chem.**
**Friedrich-Ebert-Strasse 45**
**D-4220 Dinslaken (DE)**
Erfinder : **Rehberg, Gert**
**Hauptstrasse 9**
**D-4236 Hamminkeln 1 (DE)**
Erfinder : **Tihanyi, Bela, Dr., Dipl.-Chem.**
**Arndtstrasse 87**
**D-4200 Oberhausen 1 (DE)**
Erfinder : **Weber, Jürgen, Dr., Dipl.-Chem.**
**Bunsenstrasse 17**
**D-4200 Oberhausen 13 (DE)**

(74) Vertreter : **Reichelt, Karl-Heinz, Dr. et al**
**m. Br. Ruhrchemie Aktiengesellschaft Abt. PLD Postfach 13 01 60**
**D-4200 Oberhausen 13 (DE)**

Imprimerie Jouve, 18, rue St-Denis, 75001 Paris, France

# Verfahren zur Herstellung von haftfähigen Schichten auf Polyolefinen

Die Erfindung betrifft ein Verfahren zur Erzeugung von Überzügen auf Polyolefinen durch Zersetzung wenigstens einer flüchtigen und thermisch leicht zersetzbaren Metallverbindung aus einem gasförmigen Gemisch mit einem Trägergas und gegebenenfalls anderen Komponenten auf einer heißen Polyolefinunterlage.

Es ist bekannt, metallische Überzüge auf Kunststoffoberflächen durch Aufsprühen geeigneter Lösungen, Bedampfen mit Metalldämpfen im Vacuum und durch Kunststoffgalvanisierung herzustellen (vgl. z.B Römpp, Chemie Lexikon, 7. Auflage 1974 ; « Kunststoffmetallisierung » Nr. 1902 und H. Domininghaus, Kunststoffe II ; Aufarbeiten, Oberflächen veredeln, Umformen ; VDI-Taschenbücher T 8, 1969).

Diese Methoden haben jedoch erhebliche Nachteile bei der Beschichtung von Kunststoffen, insbesondere Polyolefinen. Nach dem Aufsprühverfahren werden z.B. Silberüberzüge auf Kunststoffoberflächen durch Aufsprühen einer Silbersalzlösung und eines Reduktionsmittels erhalten. Dabei entsteht ein glänzender Silberspiegel, der jedoch im allgemeinen ungleichmäßige Schichtdicke und schlechte Haftfestigkeit aufweist. Teile des Metallbelages können bereits bei leichter mechanischer Beanspruchung in Form von flachen Plättchen abblättern.

Metallische Beläge auf Kunststoffen erhält man heute überwiegend nach dem Hochvakuum-Bedampfungsverfahren. Das Arbeiten im Hochvakuum bei $10^{-3}$ - $10^{-5}$ mbar erfordert aber kostspielige Einrichtungen mit komplizierten Techniken, wodurch der Anwendungsbereich derart beschichteter Kunststoffteile aus Wirtschaftlichkeitsgründen nur auf spezielle Gebiete beschränkt bleibt. Hinzu kommt, daß die Beschichtung mit schwerverdampfbaren Metallen, wie Wolfram, nur mit Elektronenstrahl-Heizern möglich ist (s. Kirk-Othmer, Encyclopedia of chemical technology, 2nd Edition 1967, Vol. 13, S. 249-284). Weitere Nachteile dieser Methode hat man durch umständliche, mehrfache Vorbehandlung der Oberfläche zu vermeiden versucht (vgl. Firmenschrift Hostalen PP « Metallisieren im Hochvacuum » der Hoechst AG).

Ferner lassen sich Polyolefine nach dem Verfahren der Kunststoffgalvanisierung beschichten, wobei zuvor die Oberfläche leitfähig gemacht werden muß. Diese Technik wird vorwiegend bei ABS-Propfcopolymeren angewandt.

Es ist außerdem bekannt, Metallplatinen durch thermische Zersetzung leicht zersetzbarer Metallverbindung an heißen Metalloberflächen zu beschichten. Diese Methode wurde auch auf Kunststoffe höherer thermischer Belastbarkeit, z.B. Polyester, PTFE und auf ABS-Polymeren, übertragen, nicht jedoch auf Polyolefine.

Wegen der relativ niedrigen Kristallitschmelzpunkte der Polyolefine, der schlechten Haftfestigkeit der nach den aufgeführten Verfahren hergestellten Metallschichten auf dem Polyolefin und der erforderlichen Vorbehandlung der Kunststoff-Oberfläche durch Glimmentladung oder Behandeln in einer Vakuumkammer erwies sich die Beschichtung von Polyolefinen als technisch und wirtschaftlich unbefriedigend.

Obwohl der Bedarf an metallisierten Kunststoffgegenständen und insbesondere Folien (Polyester, Polyamid, PTFE) steil ansteigt und die Verwendung beschichteter Polyolefine in der Solartechnik für Verpackung und Isolierzwecke, für Kondensatoren und die Beschichtung von Rohrinnen- bzw. -außenflächen, anderen Extrudaten und Formteilen vorteilhaft wäre, stagniert der Einsatz metallisierter Polyolefine.

Es bestand daher die Aufgabe, ein umfassend anwendbares Verfahren zur Erzeugung fest haftender Schichten aus Metallen oder Metallverbindungen auf Polyolefinen zu entwickeln, das die vorstehend geschilderten Nachteile vermeidet.

Überraschenderweise wird diese Aufgabe durch ein Verfahren zur Herstellung von Schichten aus Metallen, Metalloxiden oder Metallcarbiden auf Polyolefinen gelöst, wobei in der Gasphase vorliegende, thermisch zersetzbare Metallverbindungen mit der auf oder über die Zersetzungstemperatur der Metallverbindung erhitzten Oberfläche des Polyolefins in Gegenwart eines gasförmigen Trägers und/oder Reaktionsstoffes oder -stoffgemisches.

Das erfindungsgemäße Verfahren ermöglicht es, Polyolefine mit festhaftenden Metall-, Metalloxid- oder Metallcarbid-Schichten zu versehen, ohne daß die Oberfläche des Polyolefins vorbehandelt werden muß.

Die Zusammensetzung der Schicht auf dem Polyolefin ist abhängig von der Art der in der Gasphase vorliegenden thermisch zersetzbaren Metallverbindung, sowie dem gasförmigen Träger und/oder den Reaktionsstoffen oder Stoffgemischen.

Zur Beschichtung wird das Polyolefin auf Temperaturen von 50 bis 300 °C und vorzugsweise 130 bis 250 °C aufgeheizt. Die gewählte Temperatur ist abhängig von der thermischen Stabilität des Polyolefins und von der Zersetzungstemperatur der Metallverbindung. Darüber hinaus ist von Bedeutung, welche Beschichtungsart — Metall, Metalloxid oder Metallcarbid — gebildet werden soll.

Für die Beschichtung nach dem erfindungsgemäßen Verfahren geeignete Polyolefine sind insbesondere Polyethylene hoher und niedriger Dichte, hochmolekulares Polyethylen mit einem viskosimetrisch gemessenen Molekulargewicht oberhalb 1 Million, Copolymerisate des Ethylens, z.B. mit Buten, Hexen, Vinylacetat, Polypropylen und Copolymerisate des Propylens oder Polyisobutylen.

Das erfindungsgemäße Verfahren läßt sich zur Herstellung von Schichten der verschiedensten Metalle verwenden. Als Beispiele seien genannt : Vanadium, Chrom, Molybdän, Wolfram, Mangan, Eisen, Kobalt, Nickel, Rhodium, Kupfer oder Silber. Die Metalle werden in Form thermisch leicht zersetzbarer Verbindungen verwendet. Zu den Verbindungen gehören Metallcarbonyle, Organometallverbindungen wie Metallalkyle, -aryle, -aralkyle, -cyclopentadienyle und -arene. Zu den zersetzbaren Verbindungen sind ferner noch die Acetylacetonate und die Salze niederer Carbonsäuren mit bis zu 6 Kohlenstoffatomen zu zählen. Beispiele für Metallverbindungen, die im Rahmen des erfindungsgemäßen Verfahrens eingesetzt werden können, sind (die Temperaturangabe in Klammern bedeutet die Zersetzungstemperatur) :

Cycloheptatrien-chrom-tricarbonyl
$C_7H_8Cr(CO)_3$ (128 bis 130 °C)

Molybdänhexacarbonyl $Mo(CO)_6$ (150 bis 151 °C)

Wolframhexacarbonyl $W(CO)_6$ (ca. 170 °C)

Kobalt(II)-2-methylbutyrat $Co(C_4H_9COO)_2$ (<170 °C)

Cyclopentadienyl-eisen-dicarbonyl-jodid $C_5H_5$—$Fe(CO)_2J$ (etwa 119 °C)

Phenylkupfer (I) $C_6H_5Cu$ (80 °C)

Succinylo-pentacarbonyl-mangan $Mn(CO)_5$ $COCH_2$—$CH_2$—$COOH$ (97 bis 98 °C)

Tris(triphenylphosphin)rhodiumcarbonyl-wasserstoff $RhH(CO)$ $(Ph_3P)_3$ (138 °C)

Cyclopentadienyl-triphenylphosphin-methyl-nickel $NiC_5H_5(Ph_3P)Me$ (115 bis 118 °C)

Vanadiumhexacarbonyl $V(CO)_6$ (60 bis 70 °C)

Ein wichtiges Kennzeichen der neuen Arbeitsweise ist, daß die thermisch zersetzbare Metallverbindung zusammen mit einem gasförmigen Träger eingesetzt wird. Dieser Träger kann unter den gewählten Reaktionsbedingungen inert sein, d.h. er geht weder mit der Metallverbindung noch mit dem Polyolefin eine Umsetzung ein. Es ist aber auch möglich, gezielt solche gasförmigen Träger einzusetzen, die z.B. mit der Metallverbindung reagieren und zu einer Metallschicht bestimmter stofflicher Zusammensetzung führen. Beispiele für gasförmige Träger sind Stickstoff, Wasserstoff, Kohlenoxid, Kohlendioxid, Edelgase, Ammoniak, Sauerstoff, Dämpfe organischer Lösungsmittel und Wasserdampf. Der gasförmige Träger kann aus einem einzigen Stoff bestehen, es lassen sich aber auch Stoffgemische wie Luft einsetzen.

Zur Herstellung rein metallischer Schichten setzt man bevorzugt Metallalkyle, Metallaryle oder Metallverbindungen, die neben Alkyl- und/oder Arylresten auch noch andere Liganden enthalten, als thermisch zersetzbare Metallverbindung ein und verwendet als gasförmigen Träger einen inerten Stoff. Metallcarbid enthaltende Schichten werden vorzugsweise aus Metallcarbonylen gebildet. Metalloxid-Schichten erhält man aus den verschiedensten zersetzbaren Metallverbindungen, wenn man als gasförmigen Träger Sauerstoff oder ein sauerstoffhaltiges Gasgemisch verwendet.

Haftfestigkeit und Eigenschaften der auf dem Polyolefin nach dem erfindungsgemäßen Verfahren aufgebrachten Schicht ist wesentlich vom Partialdruck der Metallverbindung in der Gasphase abhängig, der durch zwei Grenzbedingungen bestimmt wird. Einerseits muß der Partialdruck möglichst gering sein, um sicherzustellen, daß das Metall in feiner, haftfähiger Form abgeschieden wird. Andererseits soll die Abscheidungsgeschwindigkeit so groß sein, daß die Beschichtung in wirtschaftlich vernünftiger Zeit erfolgt und eine unnötige Wärmebelastung des Polyolefins vermieden wird. Partialdrucke von 1 bis 500 mbar und vorzugsweise 1 bis 100 mbar haben sich besonders bewährt.

Die Struktur der auf dem Polyolefin aufgebrachten Schicht läßt sich weiterhin durch Variation von Zersetzungstemperatur und der Geschwindigkeit des Gasstromes beeinflussen. Bei geringer Geschwindigkeit des Gasstromes bildet sich der Metallbelag besonders bei langen Beschichtungsapparaturen bevorzugt an dem der Eintrittsseite zugewandten Teil des zu beschichtenden Werkstückes, während der in der Nähe des Ausgangs liegende Teil nur unzureichend beschichtet wird. Durch Erhöhung der Geschwindigkeit des Gasstromes bis auf 1,4 m sec.$^{-1}$ läßt sich dieser Nachteil aufheben. Vorzugsweise beträgt die Gasgeschwindigkeit des mit der leichtzersetzbaren Metallverbindung beladenen Trägerstoffes 1 cm/sec. bis 2 m/sec.

Überdies kann mit der Geschwindigkeit des Gasstromes die Beschichtungsgeschwindigkeit und damit die Dauer des Beschichtungsvorganges in Abhängigkeit von der Haftfestigkeit reguliert werden.

Schließlich kann durch eine höhere Geschwindigkeit des Gasstromes die Verweildauer der nichtmetallischen Zersetzungsprodukte im Reaktionsraum verringert werden. Dadurch wird vermieden, daß sie sich aufgrund der katalytischen Wirkung der abgeschiedenen Metalloberfläche in unerwünschte sekundäre Zersetzungsprodukte wie Kohlenstoff, aufspalten.

Bei höheren Geschwindigkeiten des Gasstromes empfiehlt es sich, zur Vermeidung von Substanzverlusten und zusätzlicher Vorerwärmung des Trägergases, das Gasgemisch im Kreis zu führen.

Die praktische Durchführung des erfindungsgemäßen Verfahrens ist nicht an feste Vorschriften gebunden. Zweckmäßig überführt man die thermisch zersetzbaren Metallverbindungen mit Hilfe des Trägerstoffes in die Gasphase. Dazu wird der Trägerstoff in oder über die vorzugsweise auf 40 bis 200 °C erwärmte Metallverbindung geleitet. Die Aufheizung des Polyolefins kann auf verschiedenen Wegen erfolgen, z.B. mit Hilfe eines heißen Gasstromes oder durch Induktionsheizung. Besonders bewährt hat es sich, die bei der thermischen Verarbeitung der Polyolefine, z.B. durch Pressen, Extrudieren, Spritzgießen oder Folienblasen im Polyolefin vorhandene Wärme zur Zersetzung der Metallverbindungen zu verwenden, so daß eine zusätzliche Wärmezufuhr nicht erforderlich ist.

Eine geeignete Beschichtungsapparatur besteht aus einem Verdampferteil und aus einem Zersetzungsteil. Die zersetzbare Metallverbindung wird in einem mit Einleitrohr für das Trägergas versehenen Gefäß mit Hilfe eines Heizbades verdampft. Bis zum Zersetzungsteil ist die Verdampfungsapparatur isoliert. Die Beschichtung des Werkstückes erfolgt in einem Zylinder, der mit dem Verdampfergefäß verbunden ist und durch einen elektrischen Ofen beheizt wird.

Im folgenden wird das erfindungsgemäße Verfahren durch einige Beispiele näher erläutert.

## Beispiel 1

Ein mit Benzol gereinigtes Werkstück aus ultrahochmolekularem Polyethylen (MG : >1,0 Mio) wird in einer Beschichtungsapparatur im heißen Stickstoffstrom auf 170 °C erwärmt und darauf einem Stickstoffstrom, der Wolframhexacarbonyl (Partialdruck : 1,74 mbar) enthält, ausgesetzt. Die Geschwindigkeit des Gasstromes beträgt 4,5 cm/sec. Nach einiger Zeit bildet sich auf der Oberfläche der Werkstücke ein dünner transparenter Film, der mit Zunahme der Beschichtungsdauer nach einigen Stunden einen gleichmäßig tiefschwarzen metallischen Belag ergibt. Die entstandene Beschichtung haftet fest auf der Unterlage.

## Beispiel 2

Ein mit Benzol gereinigtes Werkstück mit glatter Oberfläche aus ultrahochmolekularem Polyethylen (MG : <1,0 Mio) wird in einer Beschichtungsapparatur im heißen Stickstoffstrom auf 200 °C erwärmt und darauf einem Stickstoffstrom, der Wolframhexacarbonyl (Partialdruck : 14,1 mbar) enthält, ausgesetzt. Die Geschwindigkeit des Gasstromes beträgt 4,5 cm/sec. Bereits nach einer Stunde bildet sich eine festhaftend schwarze, metallische Schicht.

## Beispiel 3

Ein mit Benzol gereinigtes Werkstück mit rauher Oberfläche aus ultrahochmolekularem Polyethylen (MG : <1,0 Mio) wird in einer Beschichtungsapparatur im heißen Stickstoffstrom auf 150 °C erwärmt und darauf einem Stickstoffstrom, der Molybdänhexacarbonyl (Partialdruck : 1,43 mbar) enthält, ausgesetzt. Die Geschwindigkeit des Gasstromes beträgt 4,5 cm/sec. Es bildet sich ein metallisch grauer Belag aus Molybdän, der auch die Unebenheiten gleichmäßig bedeckt.

## Beispiel 4

Ein mit Benzol gereinigtes Werkstück mit rauher Oberfläche wird in der Beschichtungsapparatur im heißen Stickstoffstrom auf 180 °C erwärmt und darauf einem Stickstoffstrom, der Molybdänhexacarbonyl (Partialdruck : 6,26 mbar) enthält, ausgesetzt. Die Geschwindigkeit des Gasstromes, der im Kreis geführt wird, beträgt 27 cm/sec. Es bildet sich ein metallisch glänzender Molybdänbelag, der mit der Oberfläche fest verbunden ist.

## Beispiel 5

Ein unbehandeltes Werkstück aus ultrahochmolekularem Polyethylen wird in einer Beschichtungsapparatur im Stickstoffstrom bei einem Druck von etwa 10 mbar auf 170 °C erwärmt und darauf ein Cu-2-Methylbutyrat enthaltender Stickstoffstrom ·darübergeleitet. Auf der Oberfläche des Werkstückes scheidet sich innerhalb 2 h eine fest haftende metallische Kupferschicht ab.

## Beispiel 6

Entsprechend Beispiel 5 wird ultrahochmolekulares Polyethylen mit Kobalt jedoch unter Verwendung von Kobalt-2-methylbutyrat als zersetzbarer Metallverbindung beschichtet. Die Stickstoffmenge beträgt 80-100 l/h, die Geschwindigkeit des Gasstromes 4,5 cm/sec., die Beschichtungsdauer 1 Stunde. Die erhaltene Schicht ist braunschwarz.

## Beispiel 7

Ein extrudiertes Werkstück wird vor der Abkühlung in der Beschichtungsapparatur im $N_2$-Strom bei 27 cm/sec. Gasgeschwindigkeit mit Kupfer unter Verwendung von Phenylkupfer (I) als zersetzbarer Metallverbindung beschichtet. Die Beschichtungstemperatur beträgt anfangs etwa 130 °C und nimmt mit der Abkühlung des Werkstückes allmählich ab.

## Beispiel 8

Ein gepreßtes Werkstück wird im Anschluß an den Preßvorgang, vor der Abkühlung auf Raumtemperatur in der Beschichtungsapparatur bei etwa 130 °C im $N_2$-Strom bei 81 cm/sec. Gasgeschwindigkeit mit Vanadium, unter Verwendung von Vanadiumhexacarbonyl, als zersetzbarer Metallverbindung beschichtet. Die Beschichtungstemperatur nimmt mit Abkühlung des Werkstückes allmählich ab. Nach 10 Minuten wird die Beschichtung beendet. Die Oberfläche ist mit einem dünnen gut haftenden Metallfilm bedeckt.

## Beispiel 9 (Vergleich)

Dieses Beispiel zeigt die gegenüber Polyolefinen unterschiedliche Haftfestigkeit der Molybdänschicht auf Glas. Hierzu wird ein Stück Glasscheibe nach Reinigung mit Benzol wie in den vorhergehenden Beispielen in der Beschichtungsapparatur erwärmt und dem Stickstoffstrom, der Molybdänhexacarbonyl (Partialdruck von 6,26 mbar) enthält, ausgesetzt. Die Geschwindigkeit des Gasstromes, der im Kreis geführt wird, beträgt 27 cm/sec. Der entstandene metallische Spiegel läßt sich bereits durch Aufkleben und Abziehen eines Klebstreifens von der Glasoberfläche entfernen.

**Ansprüche**

1. Verfahren zur Herstellung von Schichten aus Metallen, Metalloxiden oder Metallcarbiden an Polyolefinen, dadurch gekennzeichnet, daß in der Gasphase vorliegende thermisch zersetzbare Metallverbindungen mit der auf oder über die Zersetzungstemperatur der Metallverbindung erhitzten Oberfläche des Polyolefins in Gegenwart eines gasförmigen Trägers und/oder Reaktionsstoffes oder -stoffgemisches in Berührung gebracht wird.

2. Verfahren nach Anspruch 1, dadurch gekennzeichnet, daß die leicht zersetzbaren Metallverbindungen Metallalkyle, -aryle, -aralkyle, -carbonyle oder ähnliche Salze niederer Carbonsäuren sind.

3. Verfahren nach Anspruch 1 und 2, dadurch gekennzeichnet, daß thermisch leicht zersetzbare Verbindungen der Metalle Vanadium, Chrom, Molybdän, Wolfram, Mangan, Eisen, Kobalt, Nickel, Rhodium, Kupfer oder Silber verwendet werden.

4. Verfahren nach Anspruch 1 bis 3, dadurch gekennzeichnet, daß als Trägerstoffe Stickstoff, Wasserstoff, Kohlenoxid, Kohlendioxid, Edelgase, Ammoniak, Sauerstoff, Dämpfe organischer Lösungsmittel oder Wasserdampf sowie deren Gemische Verwendung finden.

5. Verfahren nach Anspruch 1 bis 4, dadurch gekennzeichnet, daß das zur Beschichtung eingesetzte Polyolefin Polyethylen, insbesondere ultrahochmolekulares Polyethylen oder Polypropylen ist.

6. Verfahren nach Anspruch 1 bis 4, dadurch gekennzeichnet, daß das zu beschichtende Polyolefin ein Copolymer ist.

7. Verfahren nach Anspruch 1 bis 6, dadurch gekennzeichnet, daß die Oberfläche des zu beschichtenden Polyolefins während des Beschichtungsvorganges eine Temperatur zwischen 50 und 300 °C aufweist.

8. Verfahren nach Anspruch 7, dadurch gekennzeichnet, daß die Temperatur 130 bis 250 °C beträgt.

9. Verfahren nach Anspruch 1 bis 8, dadurch gekennzeichnet, daß die Beschichtung des Polyolefins während oder unmittelbar nach seiner thermischen Verarbeitung z.B. durch Extrudieren, Spritzgießen, Pressen, vor Abkühlung unter die Zersetzungstemperatur der Metallverbindungen durchgeführt wird.

10. Verfahren nach Anspruch 1 bis 9, dadurch gekennzeichnet, daß der Partialdruck der leicht zersetzbaren Metallverbindung im Gemisch mit dem gasförmigen Träger 0,010 bis 1,00 bar beträgt.

11. Verfahren nach Anspruch 1 bis 10, dadurch gekennzeichnet, daß die Gasgeschwindigkeit des mit der leichtzersetzbaren Metallverbindung beladenen Trägerstoffes 1 cm/sec. bis 2 m/sec. beträgt.

12. Verfahren nach Anspruch 1 bis 11, dadurch gekennzeichnet, daß der mit der leichtzersetzbaren Metallverbindung beladene Trägerstoff im Kreislauf geführt wird.

**Claims**

1. A method for producing layers of metals, metal oxides or metal carbides on polyolefins, characterised in that thermally decomposable metal compounds present in the gas phase are brought into contact with the surface of the polyolefin heated at or above the decomposition temperature of the metal compound, in the presence of a gaseous carrier and/or reactant or reactant mixture.

2. A method according to claim 1, characterised in that the readily decomposable metal compounds are metal alkyls, metal aryls, metal aralkyls, metal carbonyls or similar salts of lower carboxylic acids.

3. A method according to claims 1 and 2, characterised in that readily thermally decomposable compounds of the metals vanadium, chromium, molybdenum, tungsten, manganese, iron, cobalt, nickel, rhodium, copper or silver are used.

4. A method according to claims 1 to 3, characterised in that nitrogen, hydrogen, carbon monoxide, carbon dioxide, inert gases, ammonia, oxygen, vapours of organic solvents or steam as well as mixtures thereof are used as carriers.

5. A method according to claims 1 to 4, characterised in that the polyolefin to be coated is polyethylene, in particular ultra-high molecular weight polyethylene, or polypropylene.

6. A method according to claims 1 to 4, characterised in that the polyolefin to be coated is a copolymer.

7. A method according to claims 1 to 6, characterised in that the surface of the polyolefin to be coated is at a temperature of between 50 and 300 °C during the coating operation.

8. A method according to claim 7, characterised in that the temperature is 130 to 250 °C.

9. A method according to claims 1 to 8, characterised in that the coating of the polyolefin is carried out during or immediately after its thermal processing, e.g. by extruding, injection moulding, compression moulding, and before it has cooled below the decomposition temperature of the metal compounds.

10. A method according to claims 1 to 9, characterised in that the partial pressure of the readily decomposable metal compound admixed with the gaseous carrier is 0.010 to 1.00 bar.

11. A method according to claims 1 to 10, characterised in that the velocity of the carrier charged with the readily decomposable metal compound is 1 cm/sec. to 2 m/sec.

12. A method according to claims 1 to 11, characterised in that the carrier charged with the readily decomposable metal compound is recycled.

## Revendications

1. Procédé pour former des couches de métaux, d'oxydes métalliques ou de carbures métalliques sur des polyoléfines, caractérisé en ce que l'on met des composés métalliques décomposables à la chaleur et en phase gazeuse en contact avec la surface de la polyoléfine chauffée à la température de décomposition ou au-dessus de la température de décomposition du composé métallique en présence d'un véhicule et/ou d'un réactif ou mélange de réactif gazeux.

2. Procédé selon la revendication 1, caractérisé en ce que les composés métalliques faciles à décomposer sont des métaux-alkyles, -aryles, -aralkyles, -carbonyles ou des sels analogues d'acides carboxyliques inférieurs.

3. Procédé selon les revendications 1 et 2, caractérisé en ce que l'on utilise des composés faciles à décomposer à la chaleur des métaux vanadium, chrome, molybdène, tungstène, manganèse, fer, cobalt, nickel, rhodium, cuivre ou argent.

4. Procédé selon les revendications 1 à 3, caractérisé en ce que l'on utilise en tant que véhicules l'azote, l'hydrogène, l'oxyde de carbone, l'anhydride carbonique, des gaz rares, de l'ammoniac, de l'oxygène, des vapeurs de solvants organiques ou de la vapeur d'eau ou leurs mélanges.

5. Procédé selon les revendications 1 à 4, caractérisé en ce que la polyoléfine utilisée pour le revêtement est un polyéthylène, en particulier un polyéthylène à poids moléculaire ultra-haut ou un polypropylène.

6. Procédé selon les revendications 1 à 4, caractérisé en ce que la polyoléfine à revêtir est un copolymère.

7. Procédé selon les revendications 1 à 6, caractérisé en ce que la surface de la polyoléfine à revêtir présente une température de 50 à 300 °C au cours de l'opération de revêtement.

8. Procédé selon la revendication 7, caractérisé en ce que la température va de 130 à 250 °C.

9. Procédé selon les revendications 1 à 8, caractérisé en ce que le revêtement de la polyoléfine est réalisé durant ou immédiatement après son travail à la chaleur, par exemple par extrusion, moulage par injection, pression, avant refroidissement au-dessous de la température de décomposition des composés métalliques.

10. Procédé selon les revendications 1 à 9, caractérisé en ce que la pression partielle du composé métallique facile à décomposer en mélange avec le véhicule gazeux est de 0,010 à 1,00 bar.

11. Procédé selon les revendications 1 à 10, caractérisé en ce que la vitesse des gaz constituée par le véhicule chargé par le composé métallique facile à décomposer est de 1 cm/s à 2 m/s.

12. Procédé selon les revendications 1 à 11, caractérisé en ce que le véhicule chargé du composé métallique facilement décomposable est recyclé.